(19) **Europäisches Patentamt / European Patent Office / Office européen des brevets**

(11) **EP 1 866 976 B1**

(12) **FASCICULE DE BREVET EUROPEEN**

(45) Date de publication et mention
de la délivrance du brevet:
**17.09.2008 Bulletin 2008/38**

(21) Numéro de dépôt: **06725568.7**

(22) Date de dépôt: **05.04.2006**

(51) Int Cl.:
**H01L 35/34** *(2006.01)*     **H01L 35/14** *(2006.01)*

(86) Numéro de dépôt international:
**PCT/EP2006/061338**

(87) Numéro de publication internationale:
**WO 2006/106116 (12.10.2006 Gazette 2006/41)**

(54) **RÉALISATION DE MATÉRIAUX THERMOÉLECTRIQUES PAR MÉCANOSYNTHÈSE**

HERSTELLUNG THERMOELEKTRISCHER MATERIALIEN DURCH MECHANOSYNTHESE

MAKING THERMOELECTRIC MATERIALS BY MECHANOSYNTHESIS

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **06.04.2005 FR 0503417**

(43) Date de publication de la demande:
**19.12.2007 Bulletin 2007/51**

(73) Titulaire: **CENTRE NATIONAL DE LA RECHERCHE SCIENTIFIQUE (CNRS) 75016 Paris (FR)**

(72) Inventeurs:
• **ALLENO, Eric 94100 Saint-Maur (FR)**
• **GODART, Claude 44500 La Baule (FR)**
• **LEROY Eric 91940 Les Ulis (FR)**
• **BERARDAN, David 01570 Manziat (FR)**

(74) Mandataire: **Texier, Christian et al Cabinet Régimbeau 20, rue de Chazelles 75847 Paris Cedex 17 (FR)**

(56) Documents cités:
• **CHAPON, L ET AL: "Synthèse par broyage méchanique de CeFe4Sb12 et des composés substitués CeFe3,5Ni0,5Sb12 et CeFe4Sb11Te" COMPTES RENDUS DE L'ACADEMIE DES SCIENCES SERIE II C, 1998, pages 761-763, XP002359043 PARIS cité dans la demande**

• **JIYANG WANG ET AL: "Progress in skutterudite-based thermoelectric materials" THERMOELECTRICS, 2001. PROCEEDINGS ICT 2001. XX INTERNATIONAL CONFERENCE ON 8-11 JUNE 2001, PISCATAWAY, NJ, USA, IEEE, 8 juin 2001 (2001-06-08), pages 89-92, XP010574058 ISBN: 0-7803-7205-0**

• **PENG J ET AL: "Preparation and characterization of Fe substituted CoSb3 skutterudite by mechanical alloying and annealing" JOURNAL OF ALLOYS AND COMPOUNDS, ELSEVIER SEQUOIA, LAUSANNE, CH, vol. 381, no. 1-2, 3 novembre 2004 (2004-11-03), pages 313-316, XP004594760 ISSN: 0925-8388 cité dans la demande**

• **YANG L ET AL: "Synthesis of filled skutterudite compound La0.75Fe3CoSb12 by spark plasma sintering and effect of porosity on thermoelectric properties" JOURNAL OF ALLOYS AND COMPOUNDS, ELSEVIER SEQUOIA, LAUSANNE, CH, vol. 364, no. 1-2, 11 février 2004 (2004-02-11), pages 83-88, XP004481079 ISSN: 0925-8388**

• **KATSUYAMA S ET AL: "Thermoelectric properties of CoSb3 with dispersed FeSb2 particles" JOURNAL OF APPLIED PHYSICS, AMERICAN INSTITUTE OF PHYSICS. NEW YORK, US, vol. 88, no. 6, 15 septembre 2000 (2000-09-15), pages 3484-3489, XP012051605 ISSN: 0021-8979**

• **BERTINI LUCA ET AL: "Nanostructured Co1-xNixSb3 skutterudites: Synthesis, thermoelectric properties, and theoretical modeling" JOURNAL OF APPLIED PHYSICS, AMERICAN INSTITUTE OF PHYSICS. NEW YORK, US, vol. 93, no. 1, 1 janvier 2003 (2003-01-01), pages 438-447, XP012057689 ISSN: 0021-8979 cité dans la demande**

• TOPRAK M S ET AL: "THE IMPACT OF NANOSTRUCTURING ON THE THERMAL CONDUCTIVITY OF THERMOELECTRIC COSB3" ADVANCED FUNCTIONAL MATERIALS, WILEY VCH, WIENHEIM, DE, vol. 14, no. 12, décembre 2004 (2004-12), pages 1189-1196, XP001211395 ISSN: 1616-301X

• BERARDAN D ET AL: "Thermoelectric properties of the new skutterudites (Ce-Yb)3Fe4-x(Co/Ni) xSb12" THERMOELECTRICS, 2003 TWENTY-SECOND INTERNATIONAL CONFERENCE ON - ICT LA GRANDE MOTTE, FRANCE AUG. 17-21, 2003, PISCATAWAY, NJ, USA,IEEE, 17 août 2003 (2003-08-17), pages 64-67, XP010697185 ISBN: 0-7803-8301-X

**Description**

L'invention concerne le domaine des matériaux thermoélectriques de type skutterudites et des procédés pour réaliser de tels matériaux.

Les essais actuellement réalisés sur des matériaux thermoélectriques, ainsi que les recherches pour trouver ou réaliser de nouveaux matériaux thermoélectriques ou des nouvelles structures de matériaux ont principalement pour objectif d'augmenter l'efficacité de ceux-ci.

Ainsi, l'efficacité d'un matériau thermoélectrique utilisé pour la conversion de chaleur en puissance électrique peut être estimée à l'aide du facteur de mérite, encore noté ZT. Ce facteur augmente lorsque le pouvoir thermoélectrique, la conductivité électrique et l'inverse de la conductivité thermique du matériau augmentent.

Les skutterudites vides ou binaires, de formule générale $MX_{3+x}$ , sont des matériaux cristallins qui présentent des facteurs de mérite assez élevés du fait de leurs forts pouvoirs thermoélectriques, $x \in$ ]-0.2 ;0.2[, M étant un métal de la ligne IV, V ou VI du tableau périodique, et X étant un élément de la colonne XIV, XV ou XVI du tableau périodique.

Les skutterudites binaires cristallisent dans une structure cubique centrée (groupe d'espace 1m3), les atomes M occupant les positions cristallographiques 8c (¼ ¼ ¼), et l'atome X les positions 24g (0, y, z).

Les skutterudites remplies ou partiellement remplies de formule simplifiée générale $(R_{1-t}R'_{t})_{y}M_{x}M'_{4-x}X_{z}X'_{12-z}$ font partie des matériaux récents les plus prometteurs pour les applications thermoélectriques; ils peuvent en effet présenter un facteur de mérite plus élevé encore que celui des skutterudites binaires, « y » $\in$ ]0 ;1], « x » $\in$ [0 ;4], « z » $\in$ [0 ; ;12] , M et M' étant des métaux de la ligne IV, V ou VI du tableau périodique, X et X' étant des éléments de la colonne XIV, XV ou XVI du tableau périodique; R et R' étant des éléments électropositifs ou un mélange d'éléments électropositifs (i.e. un élément de valence comprise entre 1 et 4, choisi parmi les alcalins, les alcalino-terreux, les terres rares et les actinides dans le tableau périodique). Il est à noter que les skutterudites remplies peuvent avoir une formule générale plus complète dans la mesure ou le nombre des éléments R, M et X n'est pas limité. Elle peut alors s'écrire $(R,R',....R^{n})_{y}(M, M',...M^{m})_{4}(X,X',...X^{p})_{12}$ ou n,m, p sont des entiers.

La présence de l'atome R différencie les skutterudites remplies ou partiellement remplies des skutterudites vides ou binaires. En outre, il est souvent préférable de substituer quelques atomes M par des atomes M' adaptés pour ajuster le nombre d'électrons de valence de façon à conserver le caractère semi-conducteur ou semi-métallique. L'atome R, situé au centre d'une cage volumineuse en position 2a (0, 0, 0), peut vibrer autour de sa position d'équilibre de manière indépendante des vibrations du réseau.

Ainsi, la contribution des phonons à la conductivité thermique est diminuée, ce qui permet d'augmenter le facteur de mérite sans nécessairement diminuer la conductivité électrique.

Les plus faibles contributions des phonons à la conductivité thermique ont ainsi été observées dans les skutterudites remplies ou partiellement remplies de formule $(R_{1-t}R'_{t})_{y}M_{4-x}M'_{x}X_{12}$.

Les skutterudites remplies possèdent ainsi des facteurs de mérite élevés (ZT-1 à près de 400°C), qu'ils soient de type n (conduction par des électrons) ou de type p (conduction par des trous).

Dans la suite, nous considérerons qu'une poudre est constituée de grains de matière monocristallins ou polycristallins.

En outre, il est possible d'augmenter le facteur de mérite lorsque la taille des grains de matière diminue, ce qui est en particulier le cas pour des grains de matière nanocristallins, dont la taille est de l'ordre, ou inférieure, à quelques centaines de nanomètres. En effet, en diminuant la taille des grains de matière, on limite le libre parcours moyen des phonons, ce qui diminue leur contribution à la conductivité thermique.

Cependant, la diminution en taille des grains de matière de skutterudite est limitée du fait de l'instabilité thermodynamique que présente alors ce matériau, notamment dans le cas où la skutterudite est remplie ou pseudo-remplie.

Une première méthode classique connue de fabrication de skutterudites à l'état poudreux consiste d'abord à synthétiser par fusion puis à réaliser un recuit de longue durée avant de broyer. La production est donc extrêmement longue (de un à plusieurs jours) et coûteuse en énergie, notamment lors du recuit.

Une deuxième méthode connue de fabrication de skutterudites à l'état nanocristallin est la synthèse de skutterudites par chimie en solution.

A cet effet, une première technique consiste à produire des nanofils de $CoSb_3$ par traitement électrochimique. Cette première technique nécessite cependant un recuit ultérieur.

Une deuxième technique de synthèse consiste à réaliser des nanofils de $NaFe_4P_{12}$ par traitement hydrothermal puis recuit. Des inclusions et dopage nickel ou tellure dans les nanofils ont aussi été essayés.

Une troisième technique de synthèse consiste à réaliser des nanopoudres de $CoSb_3$, une nanopoudre étant une poudre (telles que définie plus haut) constituée de grains de matière chacun de taille inférieure au micromètre. A cet effet, une co-précipitation est mise en oeuvre, suivie d'une calcination dans l'air et d'une réduction sous hydrogène. La caractérisation par diffraction des rayons X de la matière obtenue s'avère cependant insuffisamment précise, et le traitement trop complexe à mettre en oeuvre (Bertini et coll. « Nanostructured Co1-xNixSb3 skutterudites: Synthesis, thermoelectric properties, and theoretical modeling », Journal of Applied Physics, 93 (1), p.438 (2003)).

Une quatrième technique consiste à réaliser des nanopoudres (définies ci dessus) de $CoSb_3$ par pyrolyse à jet (encore appelée « spray pyrolysis ») suivi de réduction sous hydrogène (Wojciechowski et coll. « Microstructure and transport properties of nanograined powders of CoSb3 obtained with the spray pyrolysis method », Proc. 22nd International Conférence on Thermoelectrics ICT2003, La Grande Motte, France, Août 2003, p.97).

Les mises en oeuvre de ces différentes techniques de synthèse de skutterudites dans un état proche du nanocristallin semblent néanmoins difficilement envisageables dans un contexte industriel, celles-ci étant trop complexes à mettre en oeuvre et/ou fournissant le matériau en trop petites quantités.

En outre, il serait probablement difficile, voire impossible, d'obtenir des skutterudites remplies à partir de ces techniques puisque toutes sont basées sur de la chimie en solution.

Une troisième méthode connue de fabrication de skutterudites est la synthèse de skutterudites par broyage mécanique.

A cet effet, une première technique connue de broyage consiste à préparer des skutterudites remplies au moyen d'un broyage mécanique court et violent (Chapon et coll. « Mechanical alloying of CeFe4Sb12 and substituted compounds CeFe3.5Ni0.5Sb12 and CeFe4Sb11Te » Comptes Rendus de l'Académie des Sciences. Série II c, p761-763 (1998)).

Cependant, la technique utilisée provoque une contamination importante de la poudre réalisée, notamment par l'alumine provenant du creuset et des billes utilisés pour le broyage. En outre, il subsiste une quantité non négligeable d'antimoine non allié dans les poudres. Enfin, la taille moyenne des grains de matière obtenus est d'environ 10 micromètres, ce qui est une taille très importante.

Une deuxième technique de broyage connue consiste à préparer du $CoSb_3$ par broyage mécanique (document CN1422969 ; et « Synthesis of CoSb3 skutterudite by mechanical alloying » de Yang et coll., dans Journal of Alloys and Compounds, 375, p. 229 (2004)).

Cependant, cette technique ne permet que de réaliser des skutterudites binaires, et non remplies. En outre, pour obtenir une bonne pureté pour la poudre de $CoSb_3$ (c'est à dire une quantité la plus faible possible de phases parasites), il est nécessaire de mettre en oeuvre après le broyage un recuit à au moins 700°C impliquant vraisemblablement une croissance cristalline importante de même qu'un coût énergétique.

Le document de Jiangying Peng et al. intitulé « Préparation and characterization of Fe substituted CoSb3 skutterudite by mechanical alloying and annealing » (Journal of alloys and compounds, Elsevier Sequoia, Lausanne, Suisse - vol. 381, n°1-2, 3 nov. 2004, p. 313-316) divulgue une technique similaire.

Les grains obtenus ont une taille moyenne comprise entre environ 9 et environ 20 micromètre, calculée à partir des photos prises en microscopie électronique en utilisant une règle de trois.

Le document de JIYANG WANG ET AL intitulé "Progress in skutterudite-based thermoelectric materials" THERMOELECTRICS, 2001. PROCEEDINGS ICT 2001. XX INTERNATIONAL CONFERENCE ON 8-11 JUNE 2001, PISCATAWAY, NJ, USA, IEEE, pages 89-92 divulgue un grain de poudre constitué principalement d'un alliage cristallin ayant des propriétés thermoélectriques et ayant une structure cubique, l'alliage comportant des nanofils de $NaFe_4P_{12}$ ayant une taille moyenne de diamètre 30-80nm.

Un but de l'invention est de mettre en oeuvre une technique de réalisation de skutterudites ayant des propriétés thermoélectriques sous forme de nanopoudres (définies ci dessus) sans nécessairement mettre en oeuvre d'étape de recuit à haute température.

Un autre but de l'invention est de produire des skutterudites sous forme de poudres dont les formes et les tailles de grains permettent de faciliter la mise en forme ultérieure et d'égaler ou d'améliorer les propriétés thermoélectriques du matériau.

Un autre but de l'invention est de produire des skutterudites ayant une bonne pureté, avec une quantité de phases parasites faibles.

Un autre but de l'invention est de produire des skutterudites remplies ayant une bonne pureté, avec une quantité de phases parasites faible.

Un autre but de l'invention est de trouver une technique de fabrication de skutterudites permettant une production industrielle (i.e. une production en quantités suffisantes à une échelle industrielle, et de manière reproductible).

Un autre but de l'invention est d'obtenir un matériau restant stable jusqu'à des températures élevées de l'ordre de 600°C.

Afin d'atteindre ces buts, l'invention propose, selon un premier aspect, un procédé pour réaliser un matériau, ayant de bonnes caractéristiques thermoélectriques, constitué principalement d'un alliage cristallin ayant une structure cubique, l'alliage comportant :

- un premier constituant ayant un ou plusieurs premier(s) élément(s) choisi(s) parmi les métaux de transition (lignes IV, V ou VI du tableau périodique) ;
- un deuxième constituant ayant un ou plusieurs deuxième(s) élément(s) choisi(s) parmi la colonne XIV, XV ou XVI du tableau périodique ;
- un troisième constituant ayant un ou plusieurs troisième(s) élément(s) choisi(s) parmi les terres rares, les alcalins, les alcalino-terreux ou les actinides ou un mélange de ces éléments ;

caractérisé en ce que le procédé comprend la réalisation de l'alliage par mécanosynthèse, et en ce que la mécanosynthèse est mise en oeuvre de sorte à réaliser principalement des poudres dont la taille moyenne des grains est inférieure à environ 500, voire inférieure à environ 100 nanomètres.

D'autres caractéristiques possibles de ce procédé de réalisation d'un élément thermoélectrique sont :

- la taille moyenne des grains de poudre est inférieure à environ 100 nanomètres ;
- un premier élément est du Fe, un deuxième élément est du Sb, un troisième élément est du Ce, les matériaux de départ utilisés pour la mécanosynthèse comprennent du Sb, du Fe-Sb et du Ce-Sb dont les proportions sont choisies de sorte à obtenir la composition de l'alliage souhaitée ;
- un premier élément est du Fe, un deuxième élément est du Sb, un troisième élément est du Yb, les matériaux de départ utilisés pour la mécanosynthèse comprennent du Sb, du Fe-Sb et du Yb-Sb dont les proportions sont choisies de sorte à obtenir la composition de l'alliage souhaitée ;
- un matériau de départ utilisé peut être du mischmétal ;
- la mécanosynthèse est réalisée à partir de matériaux de départ sous forme de poudres ou de feuilles ou de pièces macroscopiques plus volumineuses, les matériaux de départ choisis pouvant être des matériaux purs ou des alliages ;
- la mécanosynthèse est mise en oeuvre de sorte à obtenir une poudre constituée d'au moins 95 % de phase skutterudite ;
- la mécanosynthèse est mise en oeuvre de sorte que la matière travaillée ne dépasse pas une température limite inférieure à la température de fusion de n'importe lequel des éléments de la matière ;
- le dispositif de mécanosynthèse utilisé est mis en oeuvre en continu sans temps de repos ;
- le dispositif de mécanosynthèse utilisé est mis en oeuvre durant plusieurs périodes de temps de travail séparées par des périodes de temps de repos suffisamment longues pour que la température de la matière travaillée diminue bien en deçà de ladite température limite;
- on met en oeuvre la mécanosynthèse de sorte à apporter un travail compris entre environ 85 kilojoules et environ 430 kilojoules ;
- on met en oeuvre la mécanosynthèse de sorte à apporter une puissance massique de choc comprise entre environ 2 et environ 10 Watts par gramme de produit;
- on utilise une puissance massique de choc d'environ 4 Watts/gramme de produit ;
- le dispositif de mécanosynthèse est un broyeur planétaire comprenant des billes, une jarre et un plateau, et chaque période de temps de travail dure entre 1 heure et 5 heures pour une vitesse de rotation de la jarre comprise entre environ 750 et 1250 tours/mn, une vitesse de rotation du plateau comprise entre 400 et 600 tours/mn, et des billes choisies de sorte que le rapport de masse des billes sur masse totale de produit de départ soit compris entre environ 10 et 20 ;

- le dispositif de mécanosynthèse est en matériau apte à ne pas contaminer l'alliage lors de la mécanosynthèse, tel que l'acier ;
- la mécanosynthèse est mise en oeuvre sous atmosphère d'un gaz inerte tels que l'argon ou éventuellement l'azote ;
- le procédé comprend en outre une étape de compactage des poudres obtenues après mécanosynthèse, afin de réaliser ledit élément thermoélectrique.

Selon un deuxième aspect, l'invention propose des grains de poudre ayant des propriétés thermoélectriques constitués principalement d'un alliage cristallin ayant des propriétés thermoélectriques et ayant une structure cubique, l'alliage comportant :

- un premier constituant ayant un ou plusieurs premier(s) élément(s) choisi(s) parmi les métaux de transition ;
- un deuxième constituant ayant un ou plusieurs deuxième(s) élément(s) choisi(s) parmi la colonne XIV, XV ou XVI du tableau périodique ;
- un troisième constituant ayant un ou plusieurs troisième(s) élément(s) choisi(s) parmi les terres rares, les alcalins, les alcalino-terreux et les actinides ou un mélange de ces éléments ;

caractérisés en ce que les grains de poudre ont une forme globalement ovoïde et une taille moyenne inférieure à 500 nanomètres, voire 100 nanomètres.

D'autres caractéristiques possibles de ces grains de poudre sont :

- les éléments $M, M', ... M^n$ du premier constituant sont choisis parmi les éléments suivants : Fe, Co, Ni, Ru, Rh, Pd, Os, Ir, Pt ;
- les éléments $X, X', ..., X^p$ du deuxième constituant sont choisis parmi les éléments suivants : P, As, Sn, Sb, Si, Ge et Te ;
- les éléments $R, R', ..., R^m$ du troisième constituant sont choisis parmi les éléments suivants : La, Ce, Pr, Nd, Eu, Yb, Ba, Na, K, Ca, TI, Sr, U ;
- l'alliage est du $Ce_yFe_{4-x}Co_xSb_{12}$ du $Ce_yFe_{4-x}Ni_xSb_{12}$, du $Yb_yFe_{4-x}Ni_xSb_{12}$ ou du $Yb_yFe_{4-x}Co_xSb_{12}$" avec x compris respectivement entre 0 et 4 et y un réel non nul inférieur à 1 ;
- il est monophasé ;
- il est polycristallin.

Selon un troisième aspect, l'invention propose une matière thermoélectrique caractérisée en ce qu'elle est principalement formée d'une multitude de ces grains de poudre nanocristallins, sous forme poudreuse ou compactée.

D'autres caractéristiques, buts et avantages de l'invention ressortiront de la description qui suit, qui est purement illustrative et non limitative, et qui sera lue en regard des figures annexées sur lesquelles :

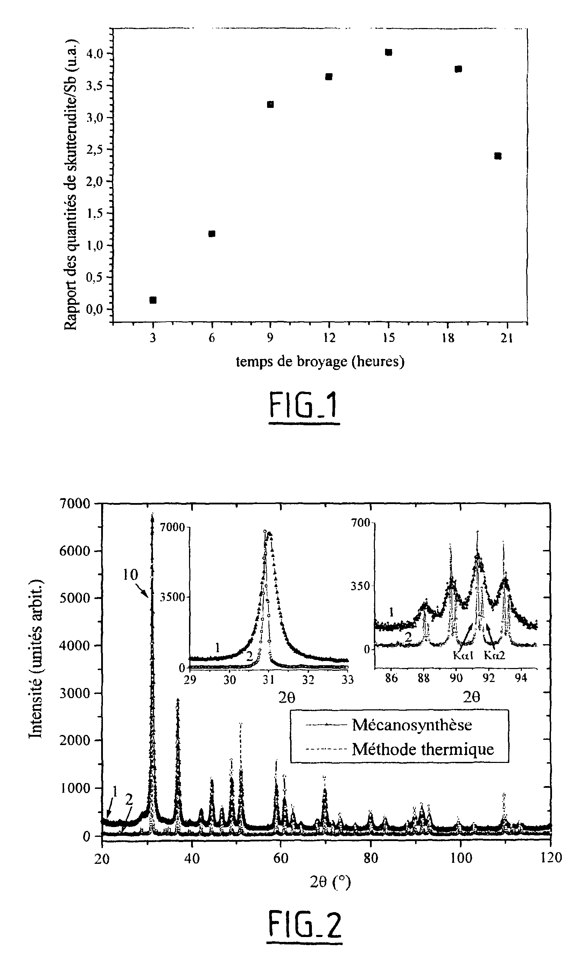

La figure 1 présente l'évolution relative de la quantité de skutterudite, par rapport à celle de Sb, produite en fonction du temps de broyage dans les conditions de l'invention.

La figure 2 présente des résultats expérimentaux de mesures en diffraction de rayons X réalisées comparativement sur une poudre obtenue selon l'invention et sur une poudre obtenue selon une technique classique, montrant que les deux phases sont les mêmes et que les poudres obtenues selon l'invention ont une taille de grains nanomètrique.

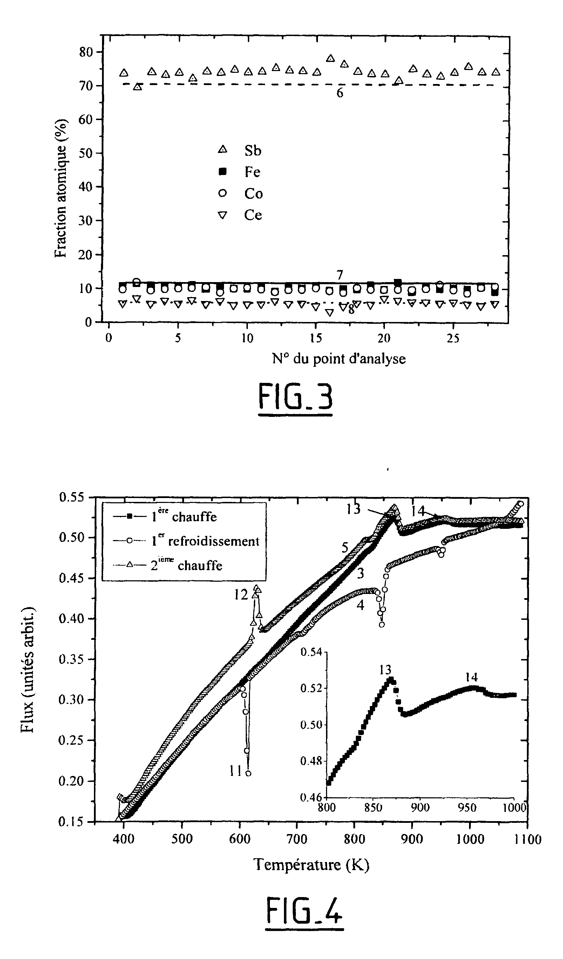

La figure 3 représente les compositions de plusieurs grains d'une poudre obtenue selon l'invention, les compositions ayant été trouvées à partir de mesures par spectroscopie de rayons X dispersés en longueur d'onde (encore appelé spectroscopie EDX pour "Energy Dispersive X ray"). Elle montre l'homogénéité de la phase produite.

La figure 4 présente des résultats expérimentaux de mesures en analyse thermique différentielle (encore appelée ATD) réalisées sur une poudre obtenue selon l'invention, montrant notamment sa stabilité thermique jusqu'à 600°C.

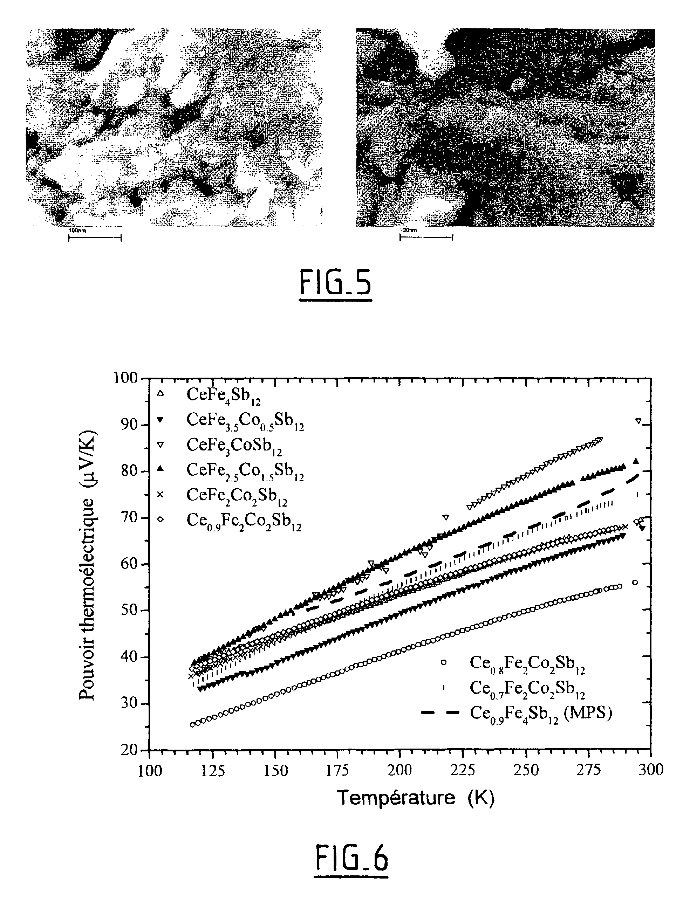

La figure 5 est une photo obtenue en microscopie électronique avec un grossissement de 200 000 montrant que les grains de matière, pour différentes natures de poudres, lorsqu'ils sont isolés (et non coalescés entre eux), ont des dimensions généralement comprises entre 15 et 50 nanomètres.

La figure 6 présente des résultats expérimentaux de mesures du pouvoir thermoélectrique, en fonction de la température, d'échantillons de poudres obtenues selon l'invention et compactées, pour différentes natures de poudre. Les valeurs sont comparables à celles obtenues pour un échantillon préparé par d'autres techniques de préparation.

L'invention propose de réaliser une matière à base d'alliage skutterudite à pouvoir thermoélectrique important, par mécanosynthèse.

La mécanosynthèse peut se définir comme un procédé mécanique de synthèse de matériaux (composés alliages, etc.) par cobroyage à sec ou en présence d'un agent de contrôle du procédé, à partir d'un matériau de départ constitué d'éléments purs ou pré-alliés dans un broyeur à haute énergie, permettant l'obtention de poudres.

On peut ainsi obtenir une matière poudreuse à très petits grains (la taille moyenne des grains de matière étant de quelques centaines de nanomètres maximum), monophasés ou polyphasés, constitués d'alliage stable ou métastable.

C'est l'énergie dégagée par le broyage qui va permettre la synthèse de l'alliage. En effet, la matière de départ subit des chocs mécaniques successifs violents (provoquant des réactions exothermiques) et est alors soumise à une succession de collage (soudage) et décollage (décohésion) des particules.

Les moyens nécessaires pour élaborer des alliages poudreux par mécanosynthèse sont les suivants :

- des composants élémentaires ou pré-alliés formant le ou les matériau(x) de départ, et comprenant les éléments de la matière à élaborer dans les proportions souhaitées ;
- un moyen de choc pour broyer la matière travaillée, qui est en général constitué de billes en matériau dur ;
- des moyens pour créer un type de mouvement permettant les chocs successifs des billes avec la matière ;
- un milieu clos ou container ou jarre dans lequel se fait la mécanosynthèse sous atmosphère contrôlée.

Le matériau constitutif du container est préférentiellement choisi de manière à ne pas occasionner de pollution de la matière travaillée. On choisira par exemple de l'acier.

Le matériau constitutif des billes est choisi de sorte à avoir une dureté ajustée pour avoir une bonne efficacité de transfert de chocs tout en évitant une contamination trop grande de la matière travaillée. On pourra ainsi choisir de l'acier. Le rapport nombre de billes sur masse total de poudre à produire est en outre ajusté pour avoir une fréquence de chocs déterminée comme optimale, pour une vitesse de billes déterminée

Le dispositif de mécanosynthèse comprend des moyens internes qui créent un mouvement, communiqué aux billes, selon des techniques qui peuvent être différentes selon le type de broyeur utilisé. Par exemple, on pourra utiliser un broyeur de type attriteur, un broyeur horizontal, un broyeur à vibrations verticales, ou un broyeur planétaire.

Le broyeur utilisé par le Demandeur dans la suite de ce document pour réaliser les poudres est un broyeur planétaire équipé de jarres en acier et d'un plateau, les jarres étant en mouvement relatifs par rapport au plateau lui même mobile, imprimant alors un mouvement aux billes en acier. Des résultats similaires auraient pu être obtenus avec d'autres types de broyeurs.

La matière poudreuse que l'on souhaite obtenir selon l'invention est constituée de skutterudite, à savoir d'un alliage cristallin cubique comportant :

- un premier constituant ayant au moins un premier élément « M » choisi parmi les métaux de transition.
- un deuxième constituant ayant au moins un deuxième élément « X » choisi parmi la colonne XIV, XV ou XVI du tableau périodique.

Selon une première variante, la skutterudite est binaire ou vide, de formule $MX_{3+x}$, telle que définie plus haut.

Selon une deuxième variante, la skutterudite est remplie ou partiellement remplie, et l'alliage comporte alors en outre :

- un troisième constituant ayant au moins un troisième élément « R » choisi parmi les terres rares, les alcalins, les alcalino-terreux ou les actinides ou un mélange de ces éléments.

Optionnellement, le premier constituant peut comprendre en outre un autre élément choisi parmi les métaux de transition, cet alliage pouvant alors avoir comme formule $R_y M_x M'_{4-x} X_z X'_{12-z}$ ou $(R,R',....R^m)_y (M, M',...M^n)_4 (X, X',...X^p)_{12}$, telle que définie plus haut.

Ledit premier élément M et les autres éléments M',...M$^m$ optionnels sont préférentiellement choisis parmi les éléments suivants : Fe, Co, Ni, Ru, Rh, Pd, Os, Ir, Pt, plus particulièrement choisi parmi le Fe, le Co et le Ni.

Ledit deuxième élément X et les autres éléments X',...,X$^p$ optionnels sont préférentiellement choisis parmi les éléments suivants : P, As, Sn, Sb, Si, Ge et Te, et peut être plus particulièrement du Sb.

Ledit troisième élément et les autres éléments R',....R$^n$ optionnels sont préférentiellement choisis parmi les éléments suivants : La, Ce, Pr, Nd, Eu, Yb, Ba, Ca, Na, K, TI, Sr, U et plus particulièrement choisi parmi Ce et Yb.

Les alliages qui ont notamment été étudiés de manière non limitative par le Demandeur sont du $Ce_{y}Fe_{4-x}Co_x Sb_{12}$ et du $Yb_y Fe_{4-x}CO_x Sb_{12}$, avec x compris respectivement entre 0 et 4, et y compris entre 0 et 1, qui sont des skutterudites partiellement remplies dont les propriétés thermoélectriques sont considérées comme importantes. Pour illustration de ces propriétés électriques, on pourra consulter par exemple le document US 6 069 312.

La fabrication des skutterudites partiellement remplies $(Ce/Yb)_y Fe_{4-x}Co_x Sb_{12}$ par mécanosynthèse, est faite à partir de matériaux de départ sous forme de poudres ou de feuilles ou de pièces macroscopiques plus volumineuses, les matériaux de départ choisis pouvant être des matériaux purs ou des alliages (encore appelés matériaux pré-alliés).

Du fait de la ductilité importante du fer, du cérium et de l'ytterbium, il pourrait être préféré d'utiliser comme matériau de départ pour le fer un alliage Fe-Sb ou une poudre plutôt que du fer massif, et pour les terres-rares des alliages Ce-Sb ou Yb-Sb plutôt que des éléments purs.

On pourra aussi utiliser, comme un des matériaux de base, du Mischmetal qui est intéressant d'un point de vue économique.

Le Demandeur a mis en oeuvre avec succès des mécanosynthèses pour obtenir des poudres en skutterudites de tailles inférieures à 200 nanomètres en apportant un travail compris entre 85 kilojoules et 430 kilojoules.

En particulier, le Demandeur a obtenu ces résultats en mettant en oeuvre des mécanosynthèses avec des puissances massiques de choc comprises entre 2 et 10 Watts/gramme de produit pendant environ 12 heures, sous atmosphère d'argon ou d'azote, en adaptant à cet effet les paramètres et spécifications de la mécanosynthèse

Sur la figure 1, sont représentés les rapports des intensités de pics de la phase skutterudite sur des pics de la phase d'un des éléments de l'alliage (le Sb ici en l'occurrence) obtenus à partir des poudres après broyage, en fonction du temps de broyage, pour des puissances de choc comprises entre 2 et 10 W/gramme de produit.

Ces valeurs ont été directement trouvées à partir des mesures par diffraction X obtenues sur les poudres réalisées, pour différentes durées de broyage.

Les points de mesure suggèrent alors une courbe ayant un maximum de phase skutterudite correspondant à une durée de broyage d'environ 12 h.

Un broyage mis en oeuvre à des puissances de choc raisonnables (entre 2 et 10 Watts/gramme de produit), pendant une durée assez longue (12 heures), permet donc d'obtenir une grande proportion de phase skutterudite.

Les réalisations de poudres de skutterudites ont notamment été effectuées par le Demandeur sous une atmosphère inerte d'argon avec des puissances massiques de choc d'environ 4 Watts/gramme de produit. En particulier, le Demandeur a utilisé un rapport de masse billes/produit de départ de 15/1. De bons résultats ont notamment été obtenus en utilisant une vitesse de rotation de 1020 tours.min$^{-1}$ pour la jarre et 510 tours.min$^{-1}$ pour le plateau

La durée du broyage choisi était d'environ 12 heures. Le broyage a été mis en oeuvre de sorte que la matière travaillée ne dépasse pas une température limite correspondant à environ la température de fusion d'aucun des éléments en présence (ici, la température limite correspond à la fusion de Sb à environ 630°C).

Dans des cas, le Demandeur a mis en oeuvre le broyage durant plusieurs périodes de temps de travail séparées par des périodes de temps de repos suffisamment longues pour que la température de la matière travaillée diminue bien en deçà de ladite température de fusion.

Par exemple, le Demandeur a mis en oeuvre le broyage par périodes de 4 heures séparées par des durées d'une heure.

Dans d'autres cas, le Demandeur a mis en oeuvre avec succès des broyages en continu, sans temps de repos.

La figure 2 représente deux diffractogrammes de rayons X (donnant en ordonnées les intensités « I » en unité arbitraire) de deux échantillons de composition $Ce_{0,9}Fe_4 Sb_{12}$, l'un préparé par mécanosynthèse selon l'invention (avec les paramètres pré-détaillés) correspondant à la courbe 1, alors que la courbe 2 correspond à l'autre échantillon préparé par co-fusion des éléments, broyage, et un recuit de longue durée à 700°C selon la technique classique.

Deux fenêtres apparaissent montrant des parties agrandies des deux diffractogrammes, autour respectivement de 31 ° et de 90° d'angle de diffraction (« 2θ »).

Hormis le petit épaulement au pied, côté gauche, du pic principal 10 (mettant en évidence une présence en très petite quantité de Sb), tous les pics de la courbe 1 correspondent aux pics de la courbe 2. Etant donné que la structure cristalline est principalement skutterudite pour le matériau correspondant à la courbe 2, on peut en déduire qu'elle l'est également pour le matériau selon l'invention correspondant à la courbe 1. Un broyage mis en oeuvre durant une durée voisine de 12 heures permet donc d'obtenir une phase skutterudite de très bonne pureté.

Par comparaison avec le composé obtenu par voie classique (courbe 2), les pics de diffraction sont en outre très nettement élargis. Pour illustration, en observant la fenêtre de zoom centrée sur 90° (grands angles), il n'est pas possible de distinguer les raies $K\alpha 1$ et $K\alpha 2$ sur la courbe 1, contrairement à la courbe 2 sur laquelle ces deux raies se distinguent nettement pour chaque pic. On peut même observer que les différents pics de la courbe 2 sont légèrement convolués.

Cet élargissement des pics de diffraction est caractéristique d'une forte diminution de la taille des grains . La taille moyenne des grains qui diffractent de manière cohérente les rayons X est ainsi estimée être inférieure à 200 nanomètres, de l'ordre de 15 à 20 nanomètres le plus souvent, par la méthode de Rietveld (H.M. Rietveld, Acta Cryst. 22, 151 (1967) et J. Applied Cryst. 2, 65 (1969)).

En référence à la figure 5, le Demandeur a confirmé ces valeurs au moyen d'observations en microscopie électronique en transmission. Dans ce dernier cas, les tailles de grains de matière sont de l'ordre de 10 à 50 nanomètres, ces grains de matière sont donc nanocristallins ou nano-polycristallins.

Les affinements réalisés par la méthode de Rietveld ont en outre montré que la phase cristalline est composée pour environ 95% de phase skutterudite. Le Demandeur a donc réalisé des poudres de skutterudites relativement pures (>95% de phase skutterudite) sous forme nanocristalline par mécanosynthèse. Les grains de poudres sont principalement polycristallins.

En outre, cette photo montre clairement que les grains obtenus par le procédé selon l'invention ont chacun une forme globalement ovoïde, voire sphérique ou quasi-sphérique. La forme obtenue ne privilégie en tout cas pas de façon claire une direction de l'espace en particulier.

Cette forme est typiquement liée au procédé de fabrication utilisée (mécanosynthèse) selon l'invention.

Cette forme de grain améliore notamment le compactage de la poudre éventuellement opéré par la suite.

Afin de déterminer les possibilités de préparation de phases thermodynamiquement métastables, le Demandeur a aussi étudié des échantillons de formule $CeFe_{4-x}Co_xSb_{12}$. Pour chacun des échantillons de cette série, les résultats obtenus par diffractogrammes de rayons X ont été similaires à ceux présentés sur la figure 2, à savoir une concordance entre les pics de la courbe 1 et ceux de la courbe 2, et un élargissement des pics de la courbe 1.

En référence à la figure 3, sont présentées les fractions atomiques (en %) déduites de résultats d'analyses quantitatives faites par spectroscopie EDX (sur un microscope électronique en transmission de type Jeol 2000FX) sur 30 grains d'une poudre préparés par mécanosynthèse selon l'invention, cette poudre ayant été préparée de sorte à avoir au final la composition nominale du $CeFe_2Co_2Sb_{12}$. Les droites horizontales 6, 7 et 8 correspondent à la composition atomique nominale du $CeFe_2Co_2Sb_{12}$, à savoir respectivement du Sb à environ 70,6 %, du Fe-Co à environ 11,8 % pour chacun, et du Ce à environ 5,9 %.

On peut observer que les résultats de stoechiométrie obtenus sont très proches de la stoechiométrie nominale (i.e. stoechiométrie idéale) : la fraction atomique du Sb est ainsi, en moyenne sur les 30 échantillons, de l'ordre de 5% seulement plus élevée que celle du composé nominal, la compensation se faisant au niveau du Fe et du Co qui, eux, ont chacun une fraction atomique moyenne de l'ordre de 2,5 % plus faible que leur fraction atomique nominale.

La composition finale de la skutterudite obtenue selon l'invention est donc très proche de la composition de la skutterudite souhaitée.

D'autre part, la composition mesurée sur trente grains est très homogène, ce qui signifie que la poudre de skutterudite produite selon l'invention est homogène (tous les grains de poudres auront des propriétés similaires).

Le comportement thermique de différentes poudres obtenues par mécanosynthèse selon l'invention a été ensuite étudié par analyse thermique différentielle (encore nommée « ATD »).

En référence à la figure 4, des résultats d'ATD de $CeFe_2Co_2Sb_{12}$ y sont présentés.

La courbe de premier chauffage 3 ne présente pas de pic à la température de fusion de l'antimoine (qui est voisine de 630°C).

L'échantillon ne contient donc que très peu d'antimoine n'ayant pas réagi, la majorité du Sb se retrouvant alors dans la phase skutterudite.

Deux pics larges 13 et 14 sont ensuite présents avec des points d'inflexion respectivement au voisinage de 830°C et autour de 920°C, correspondant respectivement au palier de décomposition péritectique de la phase skutterudite et au palier de décomposition de la phase $Fe_{4-x}Co_xSb_{12}$ résultant de la décomposition de la skutterudite.

Dans la courbe de refroidissement 4 et de second chauffage 5, des pics fins 11 et 12 sont présents autour de la température de fusion du Sb (qui se situe ici autour de 630°C). Ce Sb provient effectivement de la partie de la phase skutterudite qui s'est décomposée lors du premier chauffage 3 (autour de 830°C) et qui fusionne alors au cours du deuxième chauffage 5. L'absence de pic correspondant à la fusion de l'antimoine dans la courbe de premier chauffage 3 montre alors que la phase skutterudite est stable au moins jusqu'à 630°C.

Les mesures effectuées par ATD sur d'autres poudres de skutterudites de nature et/ou de compositions différentes ont donné des résultats similaires à ceux précédemment donnés pour la poudre de $CeFe_2Co_2Sb_{12}$.

La mise en oeuvre de la mécanosynthèse tient compte du résultat de ces mesures d'ATD, le broyage étant effectué de sorte que la matière travaillée reste à une température inférieure à une température limite déterminée par la température de fusion minimale parmi les différentes températures de fusion des différents éléments du matériau thermoélectrique (ci-dessus, la température de fusion du Sb).

A cet effet, la mécanosynthèse est mise en oeuvre (c.à.d. les jarres et le plateau sont mis en rotation si le dispositif de mécanosynthèse est un broyeur planétaire) durant plusieurs périodes de temps de travail séparées par des périodes de temps de repos suffisamment longues pour que la température de la matière travaillée diminue bien en deçà de ladite température limite.

Un exemple d'une telle mise en oeuvre de mécanosynthèse est présenté plus haut.

Une fois que la poudre thermoélectrique est réalisée, on peut alors optionnellement mettre en oeuvre une ou plusieurs étapes destinée(s) à compacter la matière poudreuse en un unique élément thermoélectrique. Les techniques connues pour réaliser une telle opération pourront alors être utilisées (compactage à chaud, à froid, frittage, etc.).

En référence à la figure 6, sont présentés des résultats de mesures de pouvoirs thermoélectriques réalisées sur des éléments thermoélectriques obtenus après compactage à 300°C sous 400 MPa de poudres de différentes skutterudites.

La mesure du pouvoir thermoélectrique permet d'estimer l'efficacité thermoélectrique d'un matériau, le pouvoir thermoélectrique S étant directement relié au facteur de mérite ZT du matériau par la formule :

$$ZT=S^2T\sigma/\kappa$$

avec T la température absolue (en Kelvin), S le pouvoir thermoélectrique (ou coefficient de Seebeck), $\sigma$ la conductivité électrique et $\kappa$ la conductivité thermique.

Le pouvoir thermoélectrique S a été mesuré de 120K à 300K sur les éléments compactés. D'après des mesures de diffraction des rayons X effectuées après compactage, aucune évolution chimique des échantillons n'a eu lieu lors de cette étape. En revanche, un léger amincissement des pics de diffraction a été observé, caractérisant une croissance des grains de poudres , ceux-ci ayant cependant leurs tailles moyennes inférieures à environ 500 nanomètres, voire à environ 100 nanomètres.

L'évolution du pouvoir thermoélectrique avec la température est présentée sur la figure 6. Comme attendu dans le cas des skutterudites, le pouvoir thermoélectrique augmente lorsque la température augmente.

Les valeurs à 300K sont du même ordre de grandeur que celles obtenues pour des échantillons préparés de manière classique par fusion-recuit.

Le Demandeur a donc produit des skutterudites à propriétés thermoélectriques sous forme nanocristalline avec une quantité très faible de phases parasites, avec une taille moyenne de grains de matière inférieure à environ 500 nanomètres, voire inférieures à environ 100 nanomètres pour des skutterudites remplies ou partiellement remplies, qui va permettre de faciliter la mise en forme ultérieure.

Ce procédé de fabrication ne comprend pas nécessairement une étape de recuit à haute température après synthèse, qui alourdirait et aurait un coût de fabrication plus important.

Un autre avantage de la mécanosynthèse est qu'elle permet une production en quantités adaptées à des productions industrielles, et une reproductibilité certaine comme l'a démontré le Demandeur.

En outre, la technique n'occasionne pas de dégradation du pouvoir thermoélectrique par rapport à la voie de synthèse classique.

En outre, les nanopoudres obtenues peuvent être compactées à 300°C sans évolution chimique.

La mécanosynthèse permet aussi de réaliser des compositions de skutterudites remplies ou partiellement remplies sous forme de nanopoudres, qui ne pouvaient être obtenues autrement du fait de la métastabilité thermodynamique qu'elles présentent, incompatible avec les méthodes de fabrication classiques.

De tels matériaux peuvent être intégrés dans des dispositifs thermoélectriques, utilisant l'effet Peltier et/ou Seebeck pour les conversions des deux formes d'énergie. On pourra par exemple coupler ces matériaux à d'autres types de matériaux pour réaliser des structures multimatériaux présentant des gradients de conductivité thermique et/ou électrique.

**Revendications**

1. Procédé pour réaliser un élément thermoélectrique constitué principalement d'un alliage cristallin ayant une structure cubique, l'alliage comportant :

   - un premier constituant ayant un ou plusieurs premier(s) élément(s) choisi(s) parmi les métaux de transition ;

- un deuxième constituant ayant un ou plusieurs deuxième(s) élément(s) choisi(s) parmi la colonne XIV, XV ou XVI du tableau périodique ;
- un troisième constituant ayant un ou plusieurs troisième(s) élément(s) choisi(s) parmi les terres rares, les alcalins, les alcalino-terreux ou les actinides ou un mélange de ces éléments ;

**caractérisé en ce que** le procédé comprend la réalisation de l'alliage par mécanosynthèse, et **en ce que** la mécanosynthèse est mise en oeuvre de sorte à réaliser principalement des poudres dont la taille moyenne de grain est inférieure à environ 500 nanomètres.

2. Procédé pour réaliser un élément thermoélectrique selon la revendication 1, **caractérisé en ce que** la taille moyenne des grains de poudre est inférieure à environ 100 nanomètres.

3. Procédé pour réaliser un élément thermoélectrique selon la revendication 1 ou 2, **caractérisé en ce qu'**un premier élément est du Fe, un deuxième élément est du Sb, un troisième élément est du Ce, les matériaux de départ utilisés pour la mécanosynthèse comprennent du Fe-Sb, du Sb et du Ce-Sb dont les proportions sont choisies de sorte à obtenir la composition de l'alliage souhaitée.

4. Procédé pour réaliser un élément thermoélectrique selon la revendication 1 ou 2, **caractérisé en ce qu'**un premier élément est du Fe, un deuxième élément est du Sb, un troisième élément est du Yb, les matériaux de départ utilisés pour la mécanosynthèse comprennent du Fe-Sb, du Sb et du Yb-Sb dont les proportions sont choisies de sorte à obtenir la composition de l'alliage souhaitée.

5. Procédé pour réaliser un élément thermoélectrique selon la revendication 1 ou 2, **caractérisé en ce qu'**un matériau de départ utilisé peut être du mischmétal.

6. Procédé pour réaliser un élément thermoélectrique selon l'une des revendications précédentes, **caractérisé en ce que** la mécanosynthèse est réalisée à partir de matériaux de départ sous forme de poudres ou de feuilles ou de pièces macroscopiques plus volumineuses, les matériaux de départ choisis pouvant être des matériaux purs ou des alliages.

7. Procédé pour réaliser un élément thermoélectrique selon l'une des revendications précédentes, **caractérisé en ce que** la mécanosynthèse est mise en oeuvre de sorte à obtenir une poudre constituée au moins à 95 % de l'alliage.

8. Procédé pour réaliser un élément thermoélectrique selon l'une des revendications précédentes, **caractérisé en ce que** la mécanosynthèse est mise en oeuvre de sorte que la matière travaillée ne dépasse pas une température limite correspondant à environ la température de fusion de n'importe lequel des éléments de la matière.

9. Procédé pour réaliser un élément thermoélectrique selon la revendication précédente, **caractérisé en ce que** le dispositif de mécanosynthèse utilisé est mis en oeuvre en continu sans temps de repos.

10. Procédé pour réaliser un élément thermoélectrique selon la revendication 8, **caractérisé en ce que** le dispositif de mécanosynthèse utilisé est mis en oeuvre durant plusieurs périodes de temps de travail séparées par des périodes de temps de repos suffisamment longues pour que la température de la matière travaillée diminue bien en deçà de ladite température de fusion.

11. Procédé pour réaliser un élément thermoélectrique selon l'une des revendications précédentes, **caractérisé en ce qu'**on met en oeuvre la mécanosynthèse de sorte à apporter un travail compris entre environ 85 kilojoules et environ 430 kilojoules.

12. Procédé pour réaliser un élément thermoélectrique selon la revendication précédente, **caractérisé en ce qu'**on met en oeuvre la mécanosynthèse de sorte à apporter une puissance massique de choc comprise entre environ 2 et environ 10 Watts par gramme de produit

13. Procédé pour réaliser un élément thermoélectrique selon la revendication précédente, **caractérisé en ce qu'**on utilise une puissance massique de choc d'environ 4 Watts/gramme de produit.

14. Procédé pour réaliser un élément thermoélectrique selon la revendication précédente, **caractérisé en ce que** le dispositif de mécanosynthèse est un broyeur planétaire comprenant des billes, une jarre et un plateau, et **en ce que** chaque période de temps de travail dure entre 1 heure et 5 heures pour une vitesse de rotation de la jarre comprise entre environ 750 et 1250 tours/mn, une vitesse de rotation du plateau comprise entre 400 et 600 tours/mn, et des billes choisies de sorte que le rapport de masse des billes sur masse totale de poudre soit compris entre environ 10 et environ 20.

15. Procédé pour réaliser un élément thermoélectrique selon l'une des revendications précédentes, **caractérisé en ce que** le dispositif de mécanosynthèse est en matériau apte à ne pas contaminer l'alliage lors de la mécanosynthèse, tel que l'acier.

**16.** Procédé pour réaliser un élément thermoélectrique selon l'une des revendications précédentes, **caractérisé en ce que** la mécanosynthèse est mise en oeuvre sous atmosphère d'un gaz inerte tel que l'argon ou l'azote.

**17.** Procédé pour réaliser un élément thermoélectrique selon l'une des revendications précédentes, **caractérisé en ce qu'**il comprend en outre une étape de compactage des poudres obtenues après mécanosynthèse, afin de réaliser ledit élément thermoélectrique.

**18.** Grain de poudre constitué principalement d'un alliage cristallin ayant des propriétés thermoélectriques et ayant une structure cubique, l'alliage comportant :

- un premier constituant ayant un ou plusieurs premier(s) élément(s) choisi(s) parmi les métaux de transition ;
- un deuxième constituant ayant un ou plusieurs deuxième(s) élément(s) choisi(s) parmi la colonne XIV, XV ou XVI du tableau périodique ;
- un troisième constituant ayant un ou plusieurs troisième(s) élément(s) choisi(s) parmi(s) les terres rares, les alcalins, les alcalino-terreux ou les actinides ou un mélange de ces éléments ;

**caractérisé en ce que** le grain de poudre a une forme globalement ovoïde et une taille moyenne inférieure à environ 500 nanomètres.

**19.** Grain de poudre selon la revendication 18, **caractérisé en ce qu'**un premier élément est choisi parmi les éléments suivants : Fe, Co, Ni, Ru, Rh, Pd, Os, Ir, Pt.

**20.** Grain de poudre selon l'une des revendications 18 à 19, **caractérisé en ce que** le premier constituant a au moins un autre premier élément choisi parmi les métaux de transition.

**21.** Grain de poudre selon la revendication précédente, **caractérisé en ce que** cet autre élément du premier constituant est choisi parmi les éléments suivants : Fe, Co, Ni, Ru, Rh, Pd, Os, Ir, Pt.

**22.** Grain de poudre selon l'une des revendications 18 à 21, **caractérisé en ce qu'**un deuxième élément est choisi parmi les éléments suivants : P, As, Sn, Sb, Si, Ge et Te.

**23.** Grain de poudre selon la revendication précédente, **caractérisé en ce que** le deuxième constituant peut avoir un autre deuxième élément choisi parmi les éléments suivants : P, As, Sn, Sb, Si, Ge et Te.

**24.** Grain de poudre selon l'une des revendications 18 à 23, **caractérisé qu'**un troisième élément est choisi parmi les éléments suivants : La, Ce, Pr, Nd, Eu, Yb, Ba, Ca, Na, K, Tl, Sr, U .

**25.** Grain de poudre selon la revendication précédente, **caractérisé en ce que** le troisième constituant peut avoir un autre troisième élément choisi parmi les éléments suivants : La, Ce, Pr, Nd, Eu, Yb, Ba, Ca, Na, K, Tl, Sr, U ou un mélange tel le mischmetal.

**26.** Grain de poudre selon la revendication 18, **caractérisé en ce que** l'alliage est du $Ce_yFe_{4-x}Co_xSb_{12}$, du $Ce_yFe_{4-x}Ni_xSb_{12}$, du $Yb_yFe_{4-x}Ni_xSb_{12}$ ou du $Yb_yFe_{4-x}Co_xSb_{12}$, avec x compris respectivement entre 0 et 4 et y compris entre 0 et 1.

**27.** Grain de poudre selon l'une des revendications 18 à 26, **caractérisé en ce qu'**il est monophasé.

**28.** Grain de poudre selon l'une des revendications 18 à 27, **caractérisée en ce qu'**il est polycristallin.

**29.** Matière thermoélectrique **caractérisée en ce qu'**elle est principalement formée de multiples grains de poudres selon l'une des revendications 18 à 28.

**30.** Matière thermoélectrique selon la revendication 29, **caractérisée en ce qu'**elle se présente sous forme non compactée.

**31.** Matière thermoélectrique selon la revendication 29, **caractérisée en ce qu'**elle se présente sous forme compactée.

**Claims**

**1.** A method for producing a thermoelectric element constituted mainly by a crystalline alloy having a cubic structure, the alloy comprising:

- a first constituent having one or more first element(s) selected from transition metals;
- a second constituent having one or more second element(s) selected from column XIV, XV or XVI of the periodic table;
- a third constituent having one or more third element(s) selected from rare earths, alkalines, alkaline earths or actinides or a mixture of these elements;

**characterised in that** the method comprises making the alloy by mechanosynthesis, and **in that** mechanosynthesis is carried out so as to mainly make powders whereof the average grain size is less than about 500 nanometres.

**2.** The method for making a thermoelectric element according to claim 1, **characterised in that** the average size of the grains of powder is less than about 100 nanometres.

3. The method for making a thermoelectric element according to claim 1 or 2, **characterised in that** a first element is Fe, a second element is Sb, a third element is Ce, the starting materials utilised for the mechanosynthesis comprise Fe-Sb, Sb and Ce-Sb whereof the proportions are selected so as to obtain the desired composition of the alloy.

4. The method for making a thermoelectric element according to claim 1 or 2, **characterised in that** a first element is Fe, a second element is Sb, a third element is Yb, the starting materials utilised for the mechanosynthesis comprise Fe-Sb, Sb and Yb-Sb whereof the proportions are selected so as to obtain the desired composition of the alloy.

5. The method for making a thermoelectric element according to claim 1 or 2, **characterised in that** a starting material utilised can be mischmetal.

6. The method for making a thermoelectric element according to any of the preceding claims, **characterised in that** mechanosynthesis is done on starting materials in the form of powders or leaves or more voluminous macroscopic pieces, the starting materials selected able to be pure materials or alloys.

7. The method for making a thermoelectric element according to any of the preceding claims, **characterised in that** mechanosynthesis is carried out so as to obtain a powder constituted at least by 95 % of the alloy.

8. The method for making a thermoelectric element according to any of the preceding claims, **characterised in that** mechanosynthesis is carried out such that the worked material does not exceed a temperature limit corresponding to about the melting temperature of any of the elements of the material.

9. The method for making a thermoelectric element according to the preceding claim, **characterised in that** the mechanosynthesis device used is employed continuously without dwell time.

10. The method for making a thermoelectric element according to claim 8, **characterised in that** the mechanosynthesis device used is employed over several work time periods separated by dwell time periods long enough for the temperature of the worked material to decrease well beyond said melting temperature.

11. The method for making a thermoelectric element according to any of the preceding claims, **characterised in that** mechanosynthesis is employed so as to contribute work of between about 85 kilojoules and about 430 kilojoules.

12. The method for making a thermoelectric element according to the preceding claim, **characterised in that** mechanosynthesis is employed so as to contribute a specific shock power of between about 2 and about 10 Watts per gram of product.

13. The method for making a thermoelectric element according to the preceding claim, **characterised in that** a specific shock power of about 4 Watts/gram of product is used.

14. The method for making a thermoelectric element according to the preceding claim, **characterised in that** the mechanosynthesis device is a planetary grinder comprising balls, a jar and a tray, and **in that** each work time period lasts between 1 hour and 5 hours for a rotation speed of the jar comprised between about 750 and 1250 rpm, a rotation speed of the tray comprised between 400 and 600 rpm, and balls selected such that the mass ratio of the balls to total mass of powder is between about 10 and about 20.

15. The method for making a thermoelectric element according to any of the preceding claims, **characterised in that** the mechanosynthesis device is made of a material likely not to contaminate the alloy during mechanosynthesis, such as steel.

16. The method for making a thermoelectric element according to any of the preceding claims, **characterised in that** mechanosynthesis is carried out under inert gas atmosphere such as argon or nitrogen.

17. The method for making a thermoelectric element according to any of the preceding claims, **characterised in that** it further comprises a compacting step for powders obtained after mechanosynthesis, to make said thermoelectric element.

18. A grain of powder constituted mainly by a crystalline alloy having thermoelectric properties and having a cubic structure, the alloy comprising:

- a first constituent having one or more first element(s) selected from transition metals;
- a second constituent having one or more second element(s) selected from column XIV, XV or XVI of the periodic table;
- a third constituent having one or more third element(s) selected from rare earths, alkalines, alkaline earths or actinides or a mixture of these elements;

**characterised in that** the grain of powder has an overall ovoid shape and an average size of less than about 500 nanometres.

19. The grain of powder according to claim 18, **characterised in that** a first element is selected from the following elements: Fe, Co, Ni, Ru, Rh, Pd, Os, Ir, Pt.

20. The grain of powder according to any of claims 18 to 19, **characterised in that** the first constituent has at least another first element selected from transition metals.

21. The grain of powder according to the preceding claim, **characterised in that** this other element of the first constituent is selected from the following elements: Fe, Co, Ni, Ru, Rh, Pd, Os, Ir, Pt.

22. The grain of powder according to any of claims 18 to 21, **characterised in that** a second element is selected from the following elements: P, As, Sn, Sb, Si, Ge and Te

23. The grain of powder according to the preceding claim, **characterised in that** the second constituent can have another second element selected from the following elements: P, As, Sn, Sb, Si, Ge and Te

24. The grain of powder according to any of claims 18 to 23, **characterised in that** a third element is selected from the following elements: La, Ce, Pr, Nd, Eu, Yb, Ba, Ca, Na, K, Tl, Sr, U

25. The grain of powder according to the preceding claim, **characterised in that** the third constituent can have another third element selected from the following elements: La, Ce, Pr, Nd, Eu, Yb, Ba, Ca, Na, K, Tl, Sr, U or a mixture such as mischmetal.

26. The grain of powder according to claim 18, **characterised in that** the alloy is $Ce_yFe_{4-x}Co_xSb_{12}$, $Ce_yFe_{4-x}Ni_xSb_{12}$, $Yb_yFe_{4-x}Ni_xSb_{12}$ or $Yb_yFe_{4-x}Co_x$-$Sb_{12}$, with x respectively between 0 and 4 and y between 0 and 1.

27. The grain of powder according to any of claims 18 to 26, **characterised in that** it is monophased.

28. The grain of powder according to any of claims 18 to 27, **characterised in that** it is polycrystalline.

29. A thermoelectric material **characterised in that** it is mainly formed from multiple grains of powders according to any of claims 18 to 28.

30. The thermoelectric material according to claim 29, **characterised in that** it is in the non-compacted form.

31. The thermoelectric material according to claim 29, **characterised in that** it is in compacted form.

**Patentansprüche**

1. Verfahren zur Herstellung eines thermoelektrischen Elements, das im Wesentlichen aus einer kristallinen Legierung mit einer kubischen Struktur besteht, wobei die Legierung umfasst:

    - einen ersten Bestandteil mit einem oder mehreren ersten, aus den Übergangsmetallen ausgewählten Element(en);
    - einen zweiten Bestandteil mit einem oder mehreren zweiten, aus den Gruppen XIV, XV oder XVI des Periodensystems ausgewählten Element(en);
    - einen dritten Bestandteil mit einem oder mehreren dritten, aus den Seltenerdmetallen, den Alkalimetallen, den Erdalkalimetallen oder den Aktiniden oder einer Mischung dieser Elemente ausgewählten Element(en);

    **dadurch gekennzeichnet, dass** das Verfahren die Herstellung der Legierung durch Mechanosynthese umfasst und dass die Mechanosynthese derart durchgeführt wird, dass hauptsächlich Pulver hergestellt werden, deren mittlere Korngröße unter etwa 500 Nanometer liegt.

2. Verfahren zur Herstellung eines thermoelektrischen Elements nach Anspruch 1, **dadurch gekennzeichnet, dass** die mittlere Größe der Pulverkörner unterhalb etwa 100 Nanometer liegt.

3. Verfahren zur Herstellung eines thermoelektrischen Elements nach Anspruch 1 oder 2, **dadurch gekennzeichnet, dass** ein erstes Element Fe ist, ein zweites Element Sb ist, ein drittes Element Ce ist, die Ausgangsmaterialien, die für die Mechanosynthese verwendet werden, Fe-Sb, Sb und Ce-Sb umfassen, deren Verhältnisse so gewählt sind, dass die Zusammensetzung der gewünschten Legierung erhalten wird.

4. Verfahren zur Herstellung eines thermoelektrischen Elements nach Anspruch 1 oder 2, **dadurch gekennzeichnet, dass** ein erstes Element Fe ist, ein zweites Element Sb ist, ein drittes Element Yb ist, die Ausgangsmaterialien, die für die Mechanosynthese verwendet werden, Fe-Sb, Sb und Yb-Sb umfassen, deren Verhältnisse so gewählt sind, dass die Zusammensetzung der gewünschten Legierung erhalten wird.

5. Verfahren zur Herstellung eines thermoelektrischen Elements nach Anspruch 1 oder 2, **dadurch ge-**

**kennzeichnet, dass** ein verwendetes Ausgangsmaterial Mischmetall sein kann.

6. Verfahren zur Herstellung eines thermoelektrischen Elements nach einem der vorangehenden Ansprüche, **dadurch gekennzeichnet, dass** die Mechanosynthese aus Ausgangsmaterialien in Form von Pulvern oder Blättern oder voluminöseren makroskopischen Stücken durchgeführt wird, wobei die Ausgangsmaterialien aus reinen Materialien oder Legierungen ausgewählt sein können.

7. Verfahren zur Herstellung eines thermoelektrischen Elements nach einem der vorangehenden Ansprüche, **dadurch gekennzeichnet, dass** die Mechanosynthese so durchgeführt wird, dass man ein Pulver erhält, das aus mindestens 95 % der Legierung besteht.

8. Verfahren zur Herstellung eines thermoelektrischen Elements nach einem der vorangehenden Ansprüche, **dadurch gekennzeichnet, dass** die Mechanosynthese so durchgeführt wird, dass das bearbeitete Material eine Temperaturgrenze, die ungefähr der Schmelztemperatur irgendeines der Elemente des Materials entspricht, nicht überschreitet.

9. Verfahren zur Herstellung eines thermoelektrischen Elements nach dem vorangehenden Anspruch, **dadurch gekennzeichnet, dass** die verwendete Mechanosynthese-Vorrichtung kontinuierlich ohne Ruhezeit eingesetzt wird.

10. Verfahren zur Herstellung eines thermoelektrischen Elements nach Anspruch 8, **dadurch gekennzeichnet, dass** die verwendete Mechanosynthese-Vorrichtung während mehrerer Arbeitszeitspannen eingesetzt wird, die durch ausreichend lange Ruhezeitspannen getrennt sind, damit die Temperatur des bearbeiteten Materials sich gut unter jene der Schmelztemperatur verringert.

11. Verfahren zur Herstellung eines thermoelektrischen Elements nach einem der vorangehenden Ansprüche, **dadurch gekennzeichnet, dass** man die Mechanosynthese so einsetzt, dass sie eine Arbeit aufbringt, die zwischen etwa 85 Kilojoule und etwa 430 Kilojoule einschließlich liegt.

12. Verfahren zur Herstellung eines thermoelektrischen Elements nach dem vorangehenden Anspruch, **dadurch gekennzeichnet, dass** man die Mechanosynthese so einsetzt, dass sie eine Massen-Stoßleistung aufbringt, die zwischen etwa 2 und etwa 10 Watt einschließlich pro Gramm Produkt liegt.

13. Verfahren zur Herstellung eines thermoelektrischen Elements nach dem vorangehenden Anspruch, **da-**

**durch gekennzeichnet, dass** man eine Massen-Stoßleistung von etwa 4 Watt/Gramm Produkt verwendet.

14. Verfahren zur Herstellung eines thermoelektrischen Elements nach dem vorangehenden Anspruch, **dadurch gekennzeichnet, dass** die Mechanosynthese-Vorrichtung ein Planetenmahlwerk ist, das Kugeln, ein Gefäß und eine Scheibe einschließt und dass jede Arbeitszeitspanne zwischen 1 Stunde und 5 Stunden bei einer Rotationsgeschwindigkeit des Gefäßes zwischen etwa 750 und 1250 Umdrehungen/min, einer Rotationsgeschwindigkeit der Scheibe zwischen etwa 400 und 600 Umdrehungen/min einschließlich dauert und die Kugeln derart gewählt sind, dass das Massenverhältnis der Kugeln zur Gesamtmasse des Pulvers zwischen etwa 10 und etwa 20 einschließlich liegt.

15. Verfahren zur Herstellung eines thermoelektrischen Elements nach einem der vorangehenden Ansprüche, **dadurch gekennzeichnet, dass** die Mechanosynthese-Vorrichtung aus einem Material ist, das angepasst ist, die Legierung während der Mechanosynthese nicht zu verunreinigen, wie Stahl.

16. Verfahren zur Herstellung eines thermoelektrischen Elements nach einem der vorangehenden Ansprüche, **dadurch gekennzeichnet, dass** die Mechanosynthese unter Inertgasatmosphäre, wie Argon oder Stickstoff, durchgeführt wird.

17. Verfahren zur Herstellung eines thermoelektrischen Elements nach einem der vorangehenden Ansprüche, **dadurch gekennzeichnet, dass** es darüber hinaus einen Schritt der Kompaktierung der erhaltenen Pulver nach der Mechanosynthese umfasst, um das thermoelektrische Element herzustellen.

18. Pulverkorn, das hauptsächlich aus einer kristallinen Legierung mit thermoelektrischen Eigenschaften besteht und eine kubische Struktur aufweist, wobei die Legierung umfasst:

 - einen ersten Bestandteil mit einem oder mehreren ersten, aus den Übergangsmetallen ausgewählten Element(en);
 - einen zweiten Bestandteil mit einem oder mehreren zweiten, aus den Gruppen XIV, XV oder XVI des Periodensystems ausgewählten Elementen;
 - einen dritten Bestandteil mit einem oder mehreren dritten, aus den Seltenerdmetallen, den Alkalimetallen, den Erdalkalimetallen oder den Aktiniden oder einer Mischung dieser Elemente ausgewählten Elementen;

**dadurch gekennzeichnet, dass** das Pulverkorn eine insgesamt eiförmige Form aufweist und dass die mittlere Größe unterhalb etwa 500 Nanometer liegt.

**19.** Pulverkorn nach Anspruch 18, **dadurch gekennzeichnet, dass** ein erstes Element aus den folgenden Elementen ausgewählt ist: Fe, Co, Ni, Ru, Rh, Pd, Os, Ir, Pt.

**20.** Pulverkorn nach einem der Ansprüche 18 bis 19, **dadurch gekennzeichnet, dass** der erste Bestandteil mindestens ein weiteres erstes Element aufweist, das aus den Übergangsmetallen ausgewählt ist.

**21.** Pulverkorn nach dem vorangehenden Anspruch, **dadurch gekennzeichnet, dass** das andere Element des ersten Bestandteils aus den folgenden Elementen ausgewählt ist: Fe, Co, Ni, Ru, Rh, Pd, Os, Ir, Pt.

**22.** Pulverkorn nach einem der Ansprüche 18 bis 21, **dadurch gekennzeichnet, dass** ein zweites Element aus den folgenden Elementen ausgewählt ist: P, As, Sn, Sb, Si, Ge und Te.

**23.** Pulverkorn nach dem vorangehenden Anspruch, **dadurch gekennzeichnet, dass** der zweite Bestandteil ein weiteres zweites Element aufweisen kann, das aus den folgenden Elementen ausgewählt ist: P, As, Sn, Sb, Si, Ge und Te.

**24.** Pulverkorn nach einem der Ansprüche 18 bis 23, **dadurch gekennzeichnet, dass** ein drittes Element aus den folgenden Elementen ausgewählt ist: La, Ce, Pr, Nd, Eu, Yb, Ba, Ca, Na, K, Tl, Sr, U.

**25.** Pulverkorn nach dem vorangehenden Anspruch, **dadurch gekennzeichnet, dass** der dritte Bestandteil ein weiteres drittes Element aufweisen kann, das aus den folgenden Elementen ausgewählt ist: La, Ce, Pr, Nd, Eu, Yb, Ba, Ca, Na, K, Tl, Sr, U oder einer Mischung, wie Mischmetall.

**26.** Pulverkorn nach Anspruch 18, **dadurch gekennzeichnet, dass** es sich bei der Legierung um $Ce_yFe_{4-x}Co_xSb_{12}$, $Ce_yFe_{4-x}Ni_xSb_{12}$, $Yb_yFe_{4-x}Ni_xSb_{12}$ oder $Yb_yFe_{4-x}Co_xSb_{12}$ handelt, wobei x jeweils zwischen 0 und 4 einschließlich liegt und y zwischen 0 und 1 einschließlich liegt.

**27.** Pulverkorn nach einem der Ansprüche 18 bis 26, **dadurch gekennzeichnet, dass** es einphasig ist.

**28.** Pulverkorn nach einem der Ansprüche 18 bis 27, **dadurch gekennzeichnet, dass** es polykristallin ist.

**29.** Thermoelektrisches Material, **dadurch gekennzeichnet, dass** es hauptsächlich aus mehreren Pulverkörnern nach einem der Ansprüche 18 bis 28 gebildet ist.

**30.** Thermoelektrisches Material nach Anspruch 29, **dadurch gekennzeichnet, dass** es in nicht-kompaktierter Form vorliegt.

**31.** Thermoelektrisches Material nach Anspruch 29, **dadurch gekennzeichnet, dass** es in kompaktierter Form vorliegt.

FIG_1

FIG_2

**FIG_3**

**FIG_4**

**FIG.5**

Légende:
- △ $CeFe_4Sb_{12}$
- ▼ $CeFe_{3.5}Co_{0.5}Sb_{12}$
- ▽ $CeFe_3CoSb_{12}$
- ▲ $CeFe_{2.5}Co_{1.5}Sb_{12}$
- × $CeFe_2Co_2Sb_{12}$
- ◇ $Ce_{0.9}Fe_2Co_2Sb_{12}$
- ○ $Ce_{0.8}Fe_2Co_2Sb_{12}$
- ' $Ce_{0.7}Fe_2Co_2Sb_{12}$
- − − $Ce_{0.9}Fe_4Sb_{12}$ (MPS)

Axe des ordonnées: Pouvoir thermoélectrique ($\mu V/K$)
Axe des abscisses: Température (K)

**FIG.6**

## RÉFÉRENCES CITÉES DANS LA DESCRIPTION

### Documents brevets cités dans la description

- CN 1422969
- US 6069312 A

### Littérature non-brevet citée dans la description

- **BERTINI.** Nanostructured Co1-xNixSb3 skutterudites: Synthesis, thermoelectric properties, and theoretical modeling. *Journal of Applied Physics,* 2003, vol. 93 (1), 438
- **WOJCIECHOWSKI.** Microstructure and transport properties of nanograined powders of CoSb3 obtained with the spray pyrolysis method. *Proc. 22nd International Conférence on Thermoelectrics ICT2003,* Août 2003, 97
- **CHAPON.** Mechanical alloying of CeFe4Sb12 and substituted compounds CeFe3.5Ni0.5Sb12 and CeFe4Sb11Te. *Comptes Rendus de l'Académie des Sciences,* 1998, 761-763
- **YANG.** Synthesis of CoSb3 skutterudite by mechanical alloying. *Journal of Alloys and Compounds,* 2004, vol. 375, 229
- Préparation and characterization of Fe substituted CoSb3 skutterudite by mechanical alloying and annealing. **JIANGYING PENG et al.** Journal of alloys and compounds. Elsevier Sequoia, 03 Novembre 2004, vol. 381, 313-316
- **JIYANG WANG et al.** Progress in skutterudite-based thermoelectric materials. *THERMOELECTRICS, 2001. PROCEEDINGS ICT 2001. XX INTERNATIONAL CONFERENCE ON 8-11 JUNE 2001,* 08 Juin 2001, 89-92
- **H.M. RIETVELD.** *Acta Cryst,* 1967, vol. 22, 151
- *J. Applied Cryst.,* 1969, vol. 2, 65